# EUROPEAN PATENT APPLICATION

(11) **EP 3 712 934 A1**
(43) Date of publication of application: **23.09.2020**
(21) Application number: 19218103.0
(22) Date of filing: 19.12.2019
(51) Int. Cl.: H01L 23/14, H01L 23/498, H01L 23/433, H01L 23/495, H01L 23/538, H01L 25/07, H01L 21/48

(54) **PACKAGE STRUCTURE AND FORMING METHOD OF THE SAME**

(30) Priority: 30.01.2019 US 201962798487 P; 27.08.2019 US 201916551717
(71) Applicant: Delta Electronics, Inc., Taoyuan City 333 (TW)
(72) Inventor: LEE, Peng-Hsin, 333 Taoyuan City (TW)
(74) Representative: Nederlandsch Octrooibureau

(57) **Abstract**

A package structure includes a first conduction layer, a second conduction layer, and an isolation layer. The first conduction layer includes a plurality of first portions, and the second conduction layer includes a plurality of portions. The isolation layer is disposed between the first conduction layer and the second conduction layer, and the isolation layer is composed of one of nitride and oxide mixed with at least one of epoxy and polymer.

## Description

### BACKGROUND

### Field of Invention

The present invention relates to a package structure and a forming method of a package structure.

### Description of Related Art

Improvements in power semiconductor device have introduced some issues. For example, when the applied voltage is higher, the thermal resistance becomes higher and the insulating ability may not be enough to withstand high voltage. Therefore, there is a need for a package structure with higher breakdown voltage and lower thermal resistance.

Furthermore, a typical lead frame may be deformed due to the weight of the chips. Therefore, the die attachment process may be unstable and the yield rate is limited. Thus, there is also a need for a package structure that makes the die attachment process be more stable.

### SUMMARY

An aspect of the present disclosure is to provide a package structure.

In some embodiments, the package structure includes a first conduction layer, a second conduction layer, and an isolation layer. The first conduction layer includes a plurality of first portions, and the second conduction layer includes a plurality of portions. The isolation layer is disposed between the first conduction layer and the second conduction layer, and the isolation layer is composed of one of nitride and oxide mixed with at least one of epoxy and polymer.

In some embodiments, the package structure further includes a conductive via disposed between and in contact with the first conduction layer and the second conduction layer.

In some embodiments, the first conduction layer further includes a second portion connecting with adjacent two of the first portions of the first conduction layer. The second portion of the first conduction layer has a top surface, and a portion of a top surface of the second portion is free from coverage of the two first portions.

In some embodiments, the package structure further includes a chip and an encapsulation. The chip is electrically connected to the first conduction layer. The chip includes a first side and a second side opposite to the first side, and the first side faces the first conduction layer. The encapsulation covers the chip and the first conduction layer.

In some embodiments, a portion of the second side of the chip is free from coverage of the encapsulation.

In some embodiments, the package structure further includes a connection structure having a first side electrically connected to the second side of the chip and the first conduction layer.

In some embodiments, the connection structure further includes a second side opposite to the first side thereof, and a portion of the second side of the connection structure is free from coverage of the encapsulation.

In some embodiments, the package structure further includes an attach material disposed between the first side of the chip and the first portions of the first conduction layer.

In some embodiments, the package structure further includes an isolation material isolating the attach material from the encapsulation.

Another aspect of the present disclosure is to provide a package structure.

The package structure includes a first conduction layer, a second conduction layer, and an isolation layer. The first conduction layer includes at least one portion, and the second conduction layer includes a plurality of portions. The isolation layer is disposed between the first conduction layer and the second conduction layer, and the isolation layer is composed of one of nitride and oxide mixed with at least one of epoxy and polymer.

In some embodiments, the package structure further includes at least one chip and a lead frame. The chip includes a first side and a second side opposite to the first side, and the second side is electrically connected to the second conduction layer. The lead frame includes a first portion electrically connected to the first side of the chip.

In some embodiments, the package structure further includes an encapsulation covering the chip, the first conduction layer, the second conduction layer, and the lead frame.

In some embodiments, a portion of a side of the first conduction layer away from the isolation layer is free from coverage of the encapsulation.

In some embodiments, the lead frame further includes a second portion. The package structure further includes a connection structure disposed between the second conduction layer and the second portion of the lead frame.

In some embodiments, the lead frame further includes a second portion extending to the second conduction layer.

In some embodiments, the package structure further includes a lead frame and a plurality of chips. The lead frame includes a plurality of portions. The chips are disposed between the second conduction layer and the lead frame, and one of the chips is free from contacting the lead frame.

In some embodiments, the package structure further includes a chip including a side that faces the first conduction layer, and the chip is electrically connected to the first conduction layer.

In some embodiments, the package structure further includes a lead frame and a pillar. The first conduction layer is disposed between the lead frame and the chip, and the pillar is disposed between the chip and the lead frame.

In some embodiments, the package structure further includes an encapsulation covering the chip, the first conduction layer, the isolation layer, the second conduction layer, and the lead frame.

In some embodiments, a number of the at least one portion of the first conduction layer is plural, and the package structure further includes a plurality of chips electrically connected to the portions of the first conduction layer.

Another aspect of the present disclosure is to provide a forming method of a package structure.

The forming method of a package structure includes forming a substrate including a first conduction layer, a second conduction layer, and an isolation layer disposed between the first conduction layer and the second conduction layer; attaching a first side of a first chip with the second conduction layer of the substrate; attaching a second side of the first chip opposite to the first side with a lead frame; and encapsulating the substrate, the chip, and the lead frame.

In some embodiments, the forming method of a package structure further includes attaching a connection structure with the second conduction layer of the substrate before attaching the second side of the first chip with the lead frame; and attaching the connection structure with the lead frame.

In some embodiments, the forming method of a package structure further includes attaching a second chip with the first conduction layer and the pillar before encapsulating the substrate, the chip, and the lead frame.

In some embodiments, the forming method of a package structure further includes attaching a pillar with the lead frame before attaching the second side of the chip with the lead frame.

In the aforementioned embodiments, the isolation layer can increase the insulating ability and provide a supporting force that prevents the first conduction layer and the second conduction layer from bending during the die attachment process. Therefore, the breakdown voltage of the package structure can be increased, and the yield rate of the package structure can be improved. Furthermore, an overlapping region can exist between the first conduction layer and the second conduction layer. Therefore, the thermal dissipation ability can be increased, and the thermal resistance can be reduced.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiment, with reference made to the accompanying drawings as follows:
Figs. 1-5 are cross-sectional views of package structures according to some embodiments of the present disclosure.
Figs. 6-10 are cross-sectional views of package structures according to some other embodiments of the present disclosure.
Fig. 11 is a flow chart of the forming method of a package structure according to one embodiment of the present disclosure.
Figs. 12A-12D are cross-sectional views of the package structure in Fig. 8 at different intermediate stages of the forming method in Fig. 11.
Fig. 13 is a flow chart of the forming method of a package structure according to one embodiment of this invention.
Figs. 14A-14F are cross-sectional views of the package structure in Fig. 9 at different intermediate stages of the forming method in Fig. 13.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

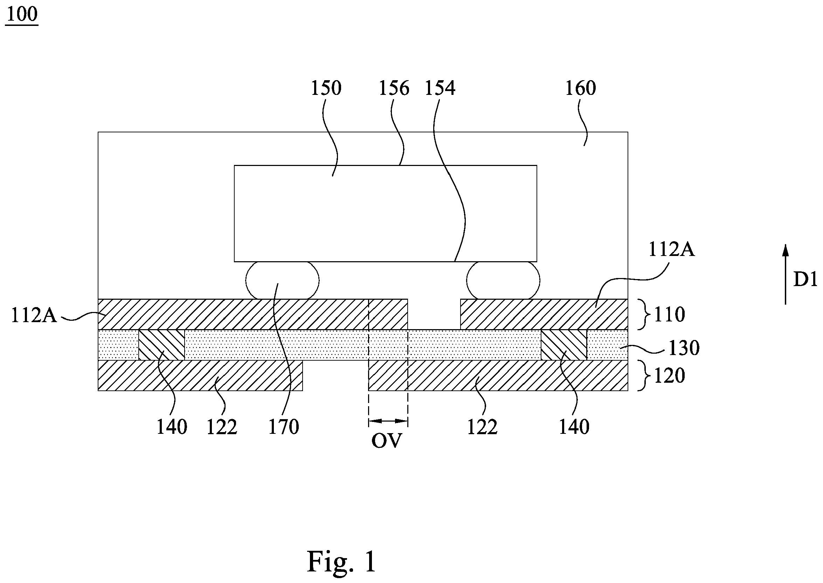

Fig. 1 is a cross-sectional view of a package structure 100 according to some embodiments of the present disclosure. The package structure 100 includes a first conduction layer 110, a second conduction layer 120, and an isolation layer 130. The first conduction layer 110 has a plurality of first portions 112A. The second conduction layer 120 has a plurality of portions 122. The first portions 112A of the first conduction layer 110 are electrically insulated and spaced apart from each other, and the portions 122 of the second conduction layer 120 are electrically insulated and spaced apart from each other. The isolation layer 130 is disposed between the first conduction layer 110 and the second conduction layer 120, and the isolation layer 130 is partially exposed from the first conduction layer 110 and the second conduction layer 120. The isolation layer 130 is composed of one of nitride and oxide mixed with at least one of epoxy and polymer. Therefore, the thickness of the isolation layer 130 can be minimized. For example, in some embodiments, the thickness of the isolation layer 130 is less than 150 micrometers and greater than 40 micrometers. In some other embodiments, the thickness of the isolation layer 130 is less than 150 micrometers and greater than 10 micrometers, but the present disclosure is not limited in this regard.

The package structure 100 further includes two conductive vias 140, a chip 150, an encapsulation 160, and an attach material 170. The conductive vias 140 are disposed between and in contact with the first conduction layer 110 and the second conduction layer 120. The first conduction layer 110 is electrically connected with the second conduction layer 120 through the conductive vias 140. Specifically, as illustrated in Fig. 1, two first portions 112A are electrically connected with two portions 122 of the second conduction layer 120 through two conduction vias 140, respectively. However, one of the first portions 112A of the first conduction layer 110 (e.g., the first portion 112A on the left-hand side) is electrically insulated from one of the portions 122 of the second conduction layer 120 (e.g., the portion 122 on the right-hand side) by the isolation layer 130. The chip 150 includes a first side 154 and a second side 156 opposite to the first side 154. The first side 154 faces the first conduction layer 110, and the second side 156 faces away from the first conduction layer 110. The attach material 170 includes a plurality of bumps each disposed between the first side 154 of the chip and the first conduction layer 110. The chip 150 is electrically connected to at least two first portions 112A of the first conduction layer 110 through a plurality of bumps of the attach material 170. The encapsulation 160 covers the chip 150, the attach material 170, and the first conduction layer 110. In the present embodiments, the second side 156 of the chip 150 is entirely covered by the encapsulation 160, and the encapsulation 160 surrounds the chip 150 and the attach material 170. As shown in Fig. 1, a portion of the isolation layer 130 that is exposed from the first conduction layer 110 is in contact with the encapsulation 160. In some embodiments, the encapsulation 160 is composed of, for example, epoxy or polymer.

A typical lead frame includes a pattern designed based on the signal transmission path between a chip (such as the chip 150) and an external device, for example, a printed circuit board. The pattern of the lead frame is at least composed of die pads, inner leads, outer leads, and bar structures that connect those leads to support the pattern of the lead frame before the chip is encapsu lated.

In the present embodiment, the first portions 112A of the first conduction layer 110 form a pattern, the portions 122 of the second conduction layer 120 form another pattern, and these two patterns are separated by the isolation layer 130. In other words, the pattern of the first conduction layer 110 and the pattern of the second conduction layer 120 connected through conductive vias 140 can form signal transmission paths that replace the typical lead frame.

However, since the isolation layer 130 is in contact with the entire pattern of the first conduction layer 110, first portions 112A of the first conduction layer 110 can be isolated from each other without connected by bar structures used in conventional package structures. Similarly, since the isolation layer 130 is in contact with the entire pattern of the second conduction layer 120, portions 122 of the second conduction layer 120 can be isolated from each other without connected by the bar structures. In other words, since the isolation layer 130 is disposed between the first conduction layer 110 and the second conduction layer 120, the patterns of the first conduction layer 110 and the second conduction layer 120 can be supported by the isolation layer 130. Therefore, the design flexibility of the patterns of the first conduction layer 110 and the second conduction layer 120 can be increased. Accordingly, the densities of the die pads and the leads (e.g., first portions 112A and portions 122) of the first conduction layer 110 and the second conduction layer 120 can be increased.

During a typical die attachment process, the lead frame is deformed due to the weight of the chip. Therefore, the yield rate of the package structure is limited. The isolation layer 130 of the present disclosure can provide a supporting force that prevents the first conduction layer 110 and the second conduction layer 120 from bending during the die attachment process. Accordingly, the die attachment process can be more stable and the yield rate of the package structure 100 can be improved.

A high power semiconductor device requires a higher insulating ability for applications with high voltage. Otherwise, when the insulating ability provided by the encapsulation 160 is not enough, device failure may happen. The isolation layer 130 of the present disclosure can increase the insulating ability, thereby increasing the breakdown voltage of the package structure 100. In some embodiments, the breakdown voltage can be increased by four times. In some embodiments, the chip 150 is a high power semiconductor device, and is composed of gallium nitride (GaN) or silicon carbide (SiC). In some other embodiments, the chip 150 is a silicon-based semiconductor device.

As shown in Fig. 1, along a first direction D1 extending from the second conduction layer 120 to the first conduction layer 110, one of the first portions 112A (on the left-hand side) of the first conduction layer 110 and one of the portions 122 (on the right-hand side) of the second conduction layer 120 that are electrically insulated from each other are partially overlapped (as indicated by the overlapping region OV). In other words, a projection of the first portion 112A (on the left-hand side) along the first direction D1 and a projection of the portion 122 (on the right-hand side) along the first direction D1 are overlapped. Therefore, the area for heat conduction can be increased. Accordingly, the thermal dissipation ability can be increased, and the thermal resistance can be reduced.

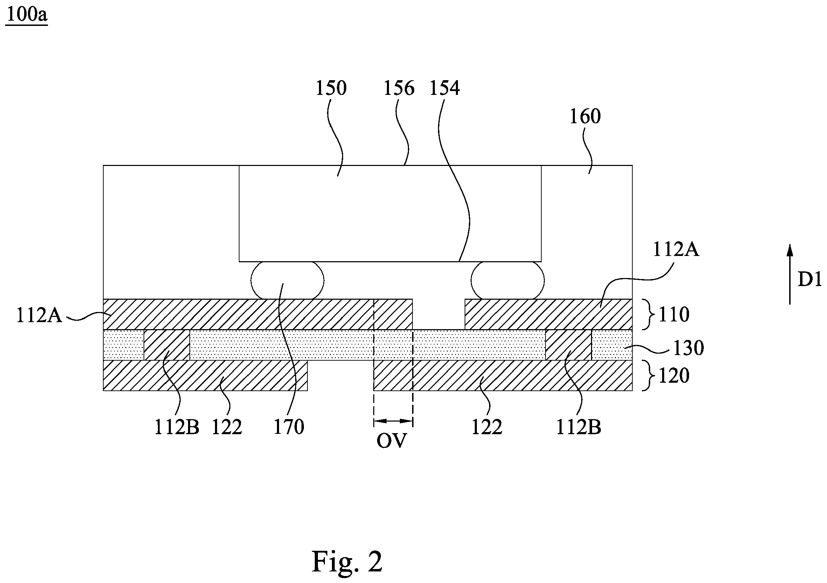

Fig. 2 is a cross-sectional view of a package structure 100a according to some embodiments of the present disclosure. The difference between the package structure 100a in Figs. 2 and the package structure 100 in Fig. 1 is that at least a portion of the second side 156 of the chip 150 is free from coverage of the encapsulation 160. In the present embodiment, as shown in Fig. 2, the entire second side 156 of the chip 150 is exposed from the encapsulation 160. In some other embodiments, at least a portion of the second side 156 is exposed from the encapsulation 160. In other words, the second side 156 of the chip 150 is partially covered by the encapsulation 160.

In some embodiments, in order to expose the second side 156 of the chip 150, the second side 156 of the chip 150 may be covered by a tape before encapsulating the chip 150, and the tape may be removed after the encapsulation 160 is formed. In some other embodiments, an upper part of the encapsulation above the chip 150 is polished to expose the second side 156 of the chip 150. Therefore, the thermal dissipation ability of the package structure 100a can be further increased.

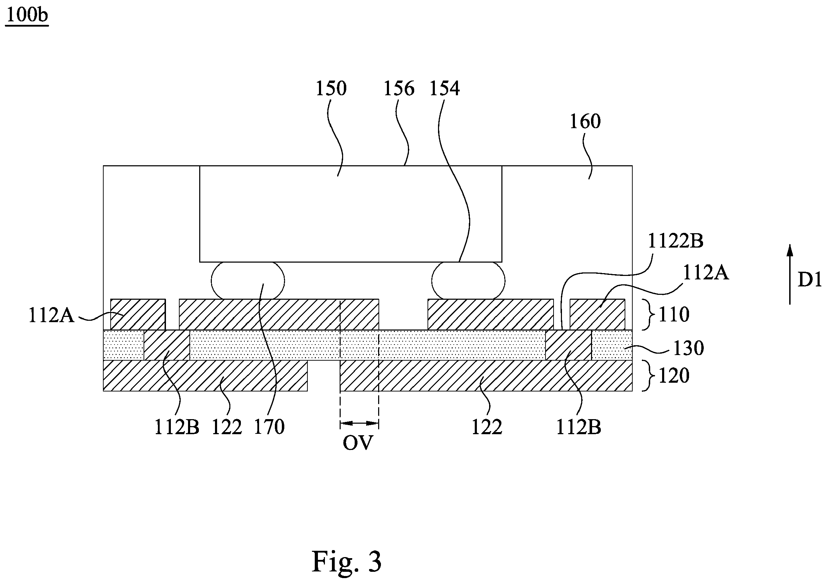

Fig. 3 is a cross-sectional view of a package structure 100b according to some embodiments of the present disclosure. The difference between the package structure 100b in Figs. 3 and the package structure 100a in Fig. 2 is the configurations of the first conduction layer 110. The first conduction layer 110 of the package structure 100b includes a plurality of second portions 112B and there is no conductive via 140. Each of the second portions 112B of the first conduction layer 110 is connected with adjacent two of the first portions 112A of the first conduction layer 110. Each of the second portions 112B of the first conduction layer 110 has a top surface 1122B, and a portion of the top surface 1122B of each of the second portions 112B is free from coverage of the adjacent two first portions 112A. In other words, the second portions 112B extend from the first portions 112A toward the second conduction layer 120 and the second portions 112B are surrounded by the isolation layer 130. Therefore, the electrical connection between the first conduction layer 110 and the second conduction layer 120 can be formed simultaneously within the same process step of forming the first conduction layer 110. As a result, the fabrication process can be simplified.

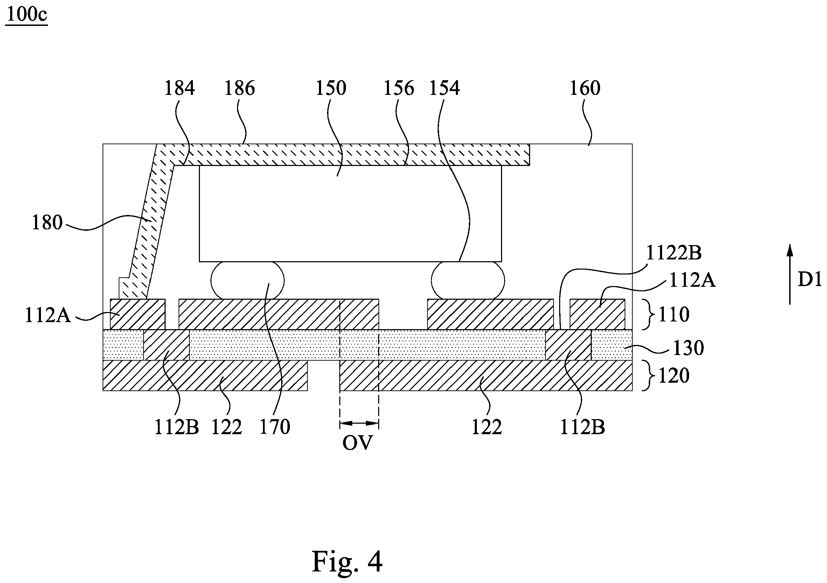

Fig. 4 is a cross-sectional view of a package structure 100c according to some embodiments of the present disclosure. The difference between the package structure 100c in Figs. 4 and the package structure 100b in Fig. 3 is that the package structure 100c further includes a connection structure 180. The connection structure 180 has a first side 184 and a second side 186 opposite to the first side 184. The first side 184 faces the second side 156 of the chip 150 and the first conduction layer 110. The connection structure 180 is electrically connected to the second side 156 of the chip 150 and the first conduction layer 110.

An area of an upper portion of the connection structure 180 that overlapped with the chip 150 along the first direction D1 is greater than an area of the second side 156 of the chip 150. In some embodiments, an area of the upper portion of the connection structure 180 is five times to ten times greater than the area of the second side 156 of the chip 150. As such, one connection structure 180 can collectively cover at least five chips 150 to increase the heat conduction area. Furthermore, the chip 150 can be grounded through the connection structure 180 by electrically connecting to the first conduction layer 110. Therefore, the thermal dissipation ability of the package structure 100c can be increased. In the present embodiments, the second portions 112B of the first conduction layer 110 can be replaced by the conductive via 140 as described about the package structure 100 illustrated in Fig. 1.

In the present embodiment, at least a portion of the second side 186 or the entire second side 186 of the connection structure 180 is free from coverage of the encapsulation 160. In some other embodiments, the second side 186 of the connection structure 180 can also be surrounded by the encapsulation 160.

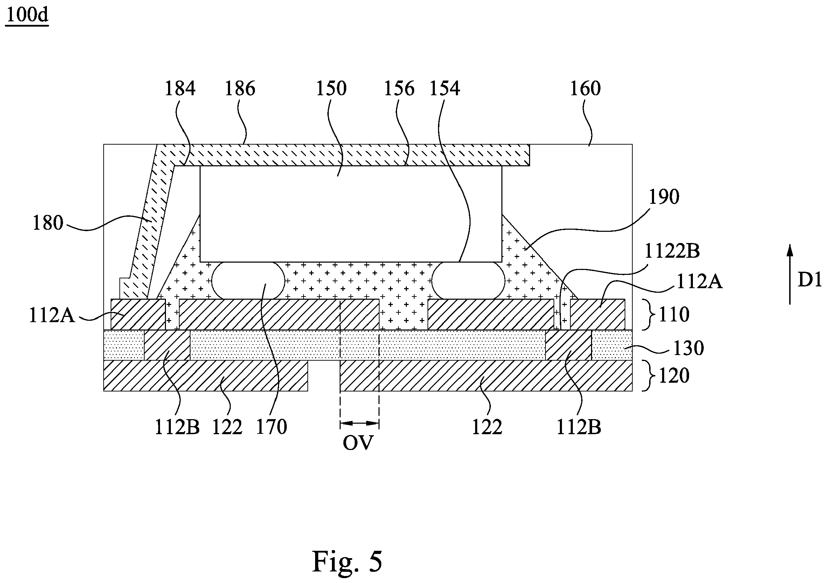

Fig. 5 is a cross-sectional view of a package structure 100d according to some embodiments of the present disclosure. The difference between the package structure 100d in Figs. 5 and the package structure 100c in Fig. 4 is that the package structure 100d further includes an isolation material 190. The isolation material 190 is disposed between the chip 150 and the first conduction layer 110 and wraps the bumps of the attach material 170. In other words, the isolation material 190 isolates the attach material 170 from the encapsulation 160. In some embodiments, the isolation material 190 is composed of similar materials as the encapsulation 160 but with higher permeability and higher resistance to voltage. Since the attach material 170 is critical to the electrical connection performance of the package structure 100d, the isolation material 190 may further protect the attach material 170. Moreover, although the attach material 170 is fragile, the isolation material 190 with high permeability can be easily formed to wrap each bumps of the attach material 170 after the chip 150 has been connected with the first conduction layer 110. Therefore, the insulating ability and the stability of the package structure 100d can be increased. In the present embodiments, the isolation material 190 further covers the top surfaces 1122B of the second portions 112B of the first conduction layer 110. In some other embodiments, the isolation material 190 can be applied to package structures of the aforementioned embodiments illustrated in Figs. 1-4.

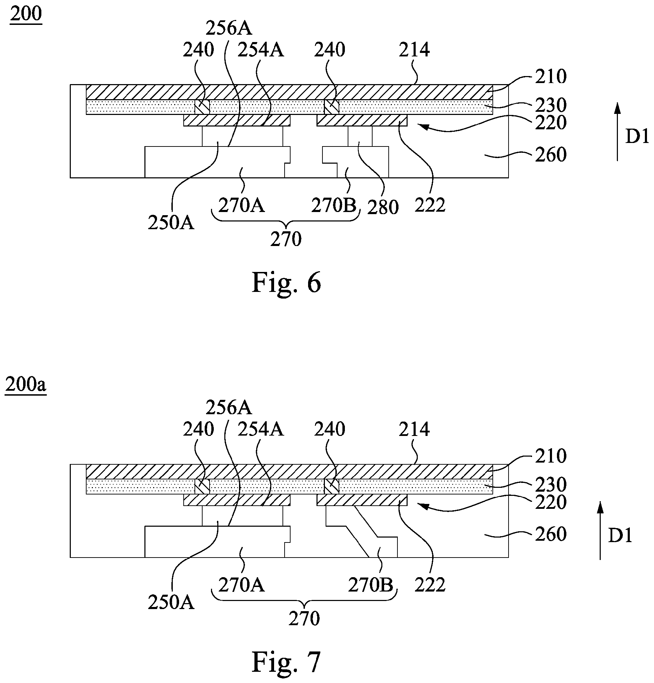

Fig. 6 is a cross-sectional view of a package structure 200 according to some embodiments of the present disclosure. The package structure 200 includes a first conduction layer 210, a second conduction layer 220, and an isolation layer 230. The first conduction layer 210 includes at least one portion. In the present embodiment, the first conduction layer 210 is composed of a single portion. The second conduction layer 220 includes a plurality of portions 222. The isolation layer 230 is disposed between the first conduction layer 210 and the second conduction layer 220, and the isolation layer 230 is partially exposed from the second conduction layer 120. The isolation layer 230 is composed of one of nitride and oxide mixed with at least one of epoxy and polymer.

The package structure 200 further includes a first chip 250A, a lead frame 270, and an encapsulation 260. The first chip 250A has a first side 254A and a second side 256A opposite to the first side 254A. The lead frame 270 includes a first portion 270A and a second portion 270B. The first portion 270A and the second portion 270B are electrically insulated from each other after the package structure 200 is encapsulated. However, as described above, the first portion 270A and the second portion 270B must be connected through bar structures before the package structure 200 is encapsulated. The second side 256A of the first chip 250A is electrically connected to the first portion 270A of the lead frame 270, and the first side 254A of the first chip 250A is electrically connected to the second conduction layer 220. The first chip 250A is attached on the lead frame 270 and the second conduction layer 220 with attach material (not shown) as described above about the package structure 100 illustrated in Fig. 1. The encapsulation 260 covers the first chip 250A, the first conduction layer 210, the second conduction layer 220, the isolation layer 230, and the lead frame 270. In the present embodiment, a side of the lead frame 270 that is away from the first chip 250A is free from coverage of the encapsulation 260.

In the present embodiment, the package structure 200 further includes two conductive vias 240 and a connection structure 280. The conductive vias 240 are electrically connected with the first conduction layer 210 and the second conduction layer 220. The connection structure 280 is disposed between the second conduction layer 220 and the second portion 270B of the lead frame 270. The second conduction layer 220 is electrically connected with the lead frame 270 through the connection structure 280.

The configuration of the first conduction layer 210, the second conduction layer 220, the isolation layer 230, and the conductive vias 240 are similar to the configuration of the first conduction layer 110, the second conduction layer 120, the isolation layer 130, and the conductive vias 140 of the package structure 100 as described above about the package structure 100 illustrated in Fig. 1. Therefore, the breakdown voltage of the package structure 200 can be increased, and the thermal resistance of the package structure 200 can be reduced. In some other embodiments, the conductive vias 240 can be replaced by portions of the first conduction layer 210 or the second conduction layer 220 as described above about the package structure 100b illustrated in Fig. 3.

In the present embodiment, the first conduction layer 210 has a side 214 that is away from the isolation layer 230. At least one portion of the side 214 or the entire side 214 of the first conduction layer 210 is free from coverage of the encapsulation 260. Therefore, the thermal dissipation ability of the package structure 200 can be increased. In some other embodiments, the side 214 of the first conduction layer 210 may be surrounded by the encapsulation 260.

Fig. 7 is a cross-sectional view of a package structure 200a according to some embodiments of the present disclosure. The difference between the package structure 200a in Fig. 7 and the package structure 200 in Fig. 6 is that the second portion 270B of the lead frame 270 extends to the second conduction layer 220, and there is no connection structure 280. In other words, the second portion 270B is directly connected with the second conduction layer 220.

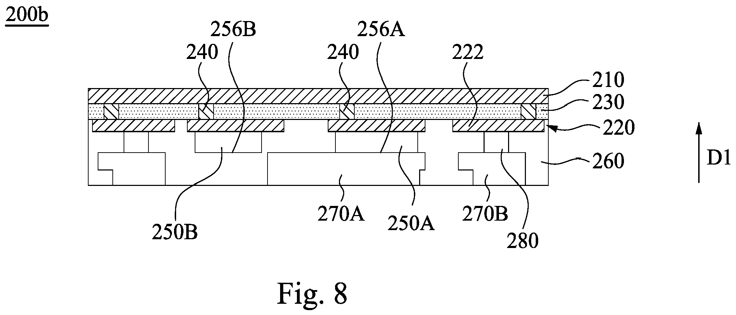

Fig. 8 is a cross-sectional view of a package structure 200b according to some embodiments of the present disclosure. The difference between the package structure 200b in Fig. 8 and the package structure 200a in Fig. 7 is that the package structure 200b further includes another first chips 250B. As shown in Fig. 8, the first chip 250B is free from contacting the lead frame 270. In other words, a projection of the first chip 250B along the first direction D1 is not overlapped with the lead frame 270. The second side 256B of the first chip 250B is in contact with the encapsulation 260, while the second side 256A of the first chip 250A is not in contact with the encapsulation 260.

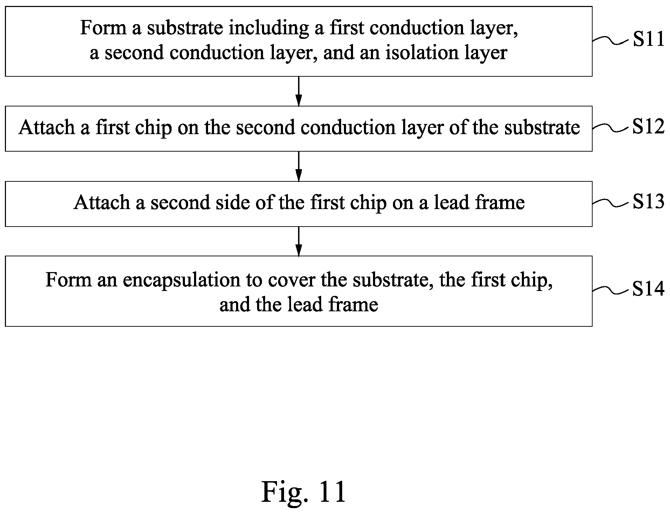

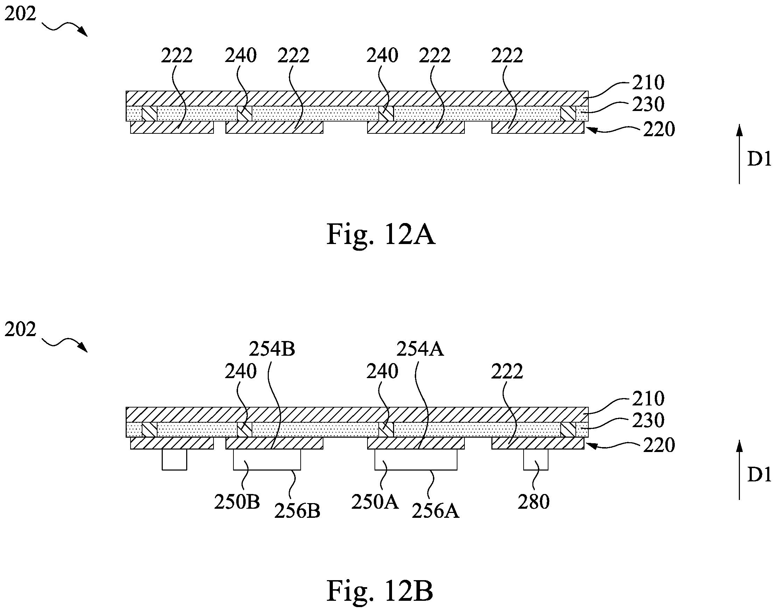

In the present embodiment, the first chip 250A and the first chip 250B are attached on the second conduction layer 220 before being attached on the lead frame 270. Therefore, there is no need for supporting the first chip 250A and the first chip 250B by the lead frame 270. Moreover, the number of the pads of the lead frame 270 is limited due to the fabrication process, while the number of the pads of the second conduction layer 220 can be greater as described in the embodiments illustrated in Figs. 1-5. Therefore, the number of the chips encapsulated in the package structure 200b can be increased. The forming method of the package structure 200b will be described in the following paragraphs accompanying Fig.11 and Figs. 12A-12D.

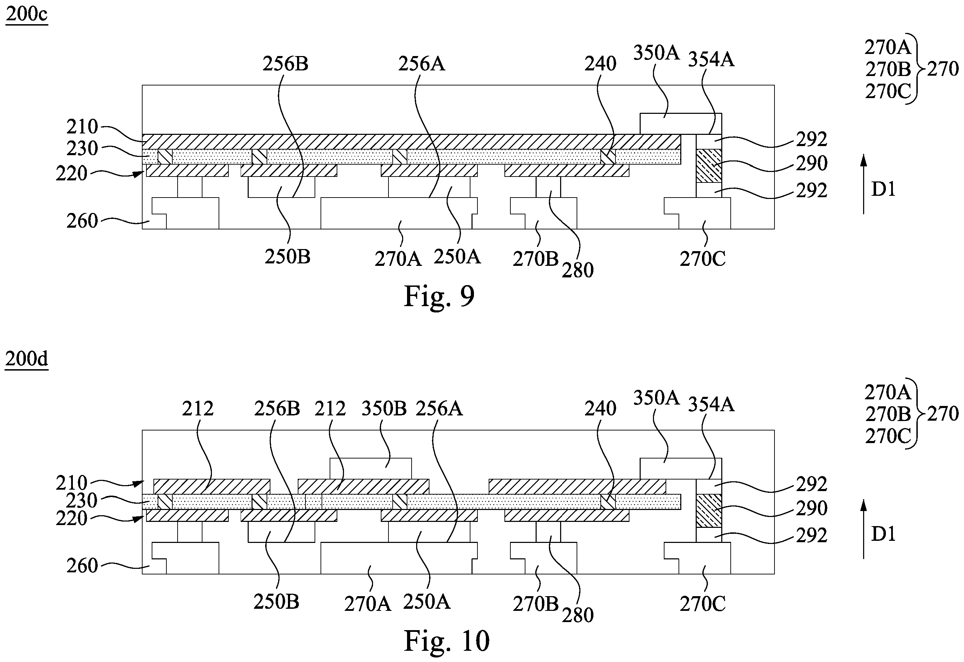

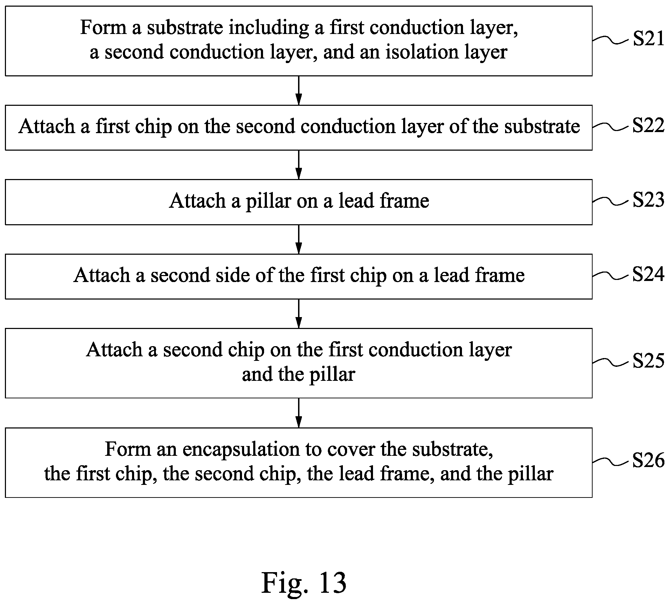

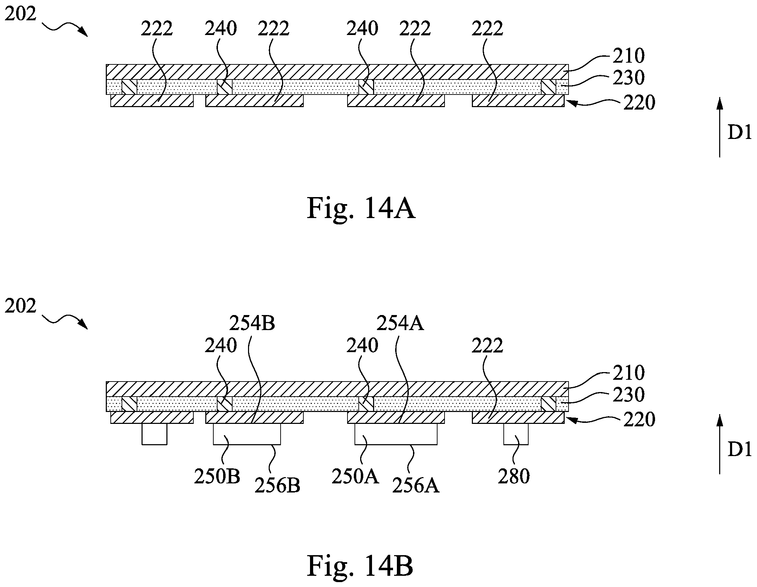

Fig. 9 is a cross-sectional view of a package structure 200c according to some embodiments of the present disclosure. The difference between the package structure 200c in Fig. 9 and the package structure 200b in Fig. 8 is that the package structure 200c further includes a second chip 350A, a pillar 290, and the lead frame 270 further includes a third portion 270C. The second chip 350A includes a side 354A facing the first conduction layer 210, and the second chip 350A is electrically connected to the first conduction layer 210. The pillar 290 is disposed between the second chip 350A and the third portion 270C of the lead frame 270. The pillar 290 is connected with the second chip 350A and the third portion 270C of the lead frame 270 through attach materials 292. The second chip 350A is electrically connected to the third portion 270C of the lead frame 270 through the pillar 290. In other words, the side 354A of the second chip 350A faces the pillar 290 and the third portion 270C of the lead frame 270. The encapsulation 260 covers the first chips 250A, 250B, the second chip 350A, the first conduction layer 210, the isolation layer 230, the second conduction layer 220, the lead frame 270, and the pillar 290. With such configuration, the number of chips encapsulated in the package structure 200c can be increased. The forming method of the package structure 200c will be described in the following paragraphs accompanying Fig.13, and Figs. 14A-14F.

Fig. 10 is a cross-sectional view of a package structure 200d according to some embodiments of the present disclosure. The difference between the package structure 200d in Fig. 10 and the package structure 200c in Fig. 9 is that the first conduction layer 210 includes a plurality of portions 212 and the package structure 200d further includes another second chips 350B. The second chip 350B is electrically connected to the portions 212 of the first conduction layer 210. Specifically, the configuration between the second chip 350B and the first conduction layer 210 is similar to the configuration between the chip 150 and the first conduction layer 110 as described above about the package structure 100 illustrated in Fig. 1 In other words, the configuration of the first conduction layer 210, the second conduction layer 220, the isolation layer 230, and the conductive vias 240 are the same as the configuration of the first conduction layer 110, the second conduction layer 120, the isolation layer 130, and the conductive via 140 of the package structure 100 as described above about the package structure 100 illustrated in Fig. 1.

The second chip 350B is electrically connected to the second conduction layer 220 sequentially through the first conduction layer 210 and the conductive vias 240. Therefore, the chips can be attached on both first conduction layer 210 and the second conduction layer 220, and the chips can be electrically connected to the lead frame 270 through connection structures 280 or pillar 290. Therefore, the number of chips that can be encapsulated in the package structure 200d can be further increased.

Fig. 11 is a flow chart of a forming method of a package structure according to some embodiments of the present disclosure. Figs. 12A-12D are cross-sectional views of the package structure 200b illustrated in Fig. 8 at different intermediate stages of the forming method in Fig. 11. Reference is made to Figs. 11 and 12A, the method starts with step S11, where a substrate 202 is formed. The substrate 202 includes a first conduction layer 210, a second conduction layer 220, and an isolation layer 230 disposed between the first conduction layer 210 and the second conduction layer 220. The first conduction layer 210 is composed of a single portion. The second conduction layer 220 includes a plurality of portions 222 electrically insulated and spaced apart from each other. The substrate 202 further includes conductive vias 240 disposed between and in contact with the first conduction layer 210 and the second conduction layer 220.

Reference is made to Figs. 11 and 12B, the method continues with step S12, where a first chip 250A is attached on the second conduction layer 220. The first chip 250A includes a first side 254A and a second side 256A opposite to the first side 254A. The first side 254A is attached to the second conduction layer 220. In the present embodiment, another first chip 250B is attached on the second conduction layer 220, and two connection structures 280 are respectively attached to other two portions 222 of the second conduction layer 220.

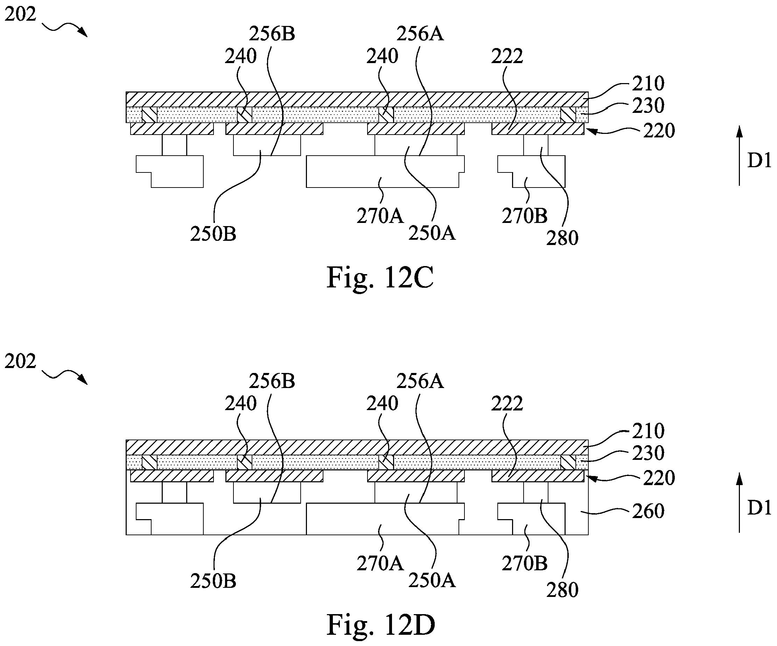

Reference is made to Figs. 11 and 12C, the method continues with step S13, where first chips 250A are attached on the lead frame 270. In the present embodiments, the connection structures 280 and the first chips 250A, are attached on the lead frame 270 simultaneously. Specifically, as shown in Fig. 12C, the second side 256A of the first chip 250A is attached on the lead frame 270, while the first chip 250B is free from contacting the lead frame 270.

Reference is made to Figs. 11 and 12D, the method continues with step S14, where the encapsulation 260 is formed. The encapsulation 260 covers the substrate 202, the first chip 250A, 250B, and the lead frame 270. As shown in Figs. 12C and 12D, the second side 256B of the first chip 250B is in contact with the encapsulation 260, while the second side 256A of the first chip 250A is not in contact with the encapsulation 260.

As discussed above about the package structure 200b illustrated in Fig. 8, the number of the pads of the lead frame 270 is limited due to the fabrication process, while the number of the pads for positioning the chips formed by the second conduction layer 220 can be greater. Therefore, the number of the pads for positioning the chips formed by the second conduction layer 220 can be greater than the number of the pads on the lead frame 270. Therefore, the number of the chips that can be encapsulated in the package structure 200b can be increased.

Fig. 13 is a flow chart of a forming method of a package structure according to some embodiments of the present disclosure. Figs. 14A-14F are cross-sectional views of the package structure 200c illustrated in Fig. 9 at different intermediate stages of the forming method in Fig. 13. Reference is made to Figs. 13 and 14A, the method starts with step S21, where a substrate 202 is formed. The forming method about the substrate 202 is the same as the forming method described in Fig. 11 and Fig. 12A. Therefore, a description in this regard will not be repeated hereinafter.

Reference is made to Figs. 13 and 14B, the method continues with step S22, where a first chip 250A is attached on the second conduction layer 220. Other structural details of step S22 are similar to those described in step S12. Therefore, a description in this regard will not be repeated hereinafter.

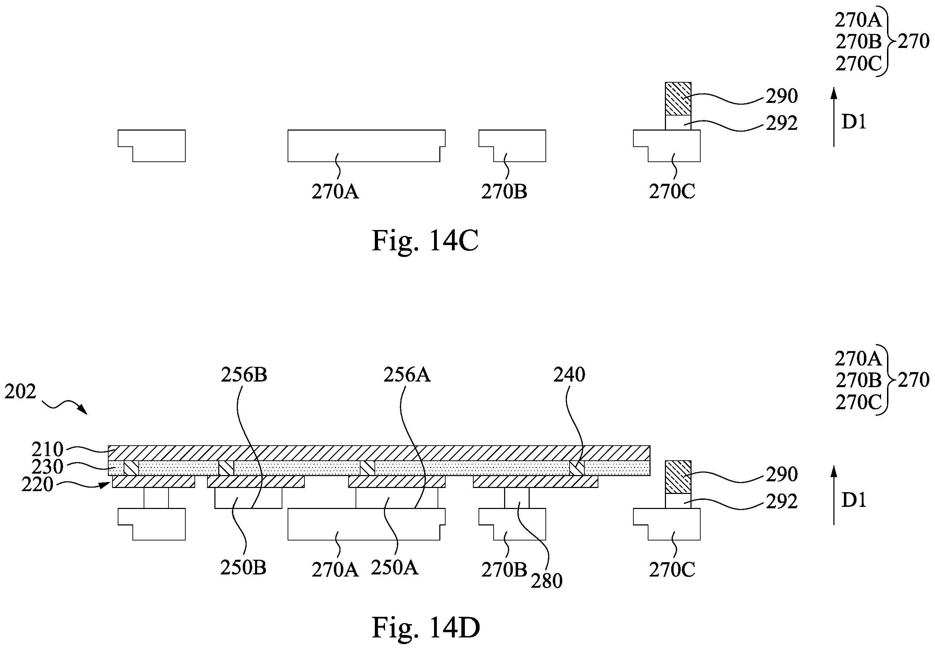

Reference is made to Figs. 13 and 14C, the method continues with step S23, where a pillar 290 is attached on the lead frame 270. The pillar 290 is attached on the third portion 270C by the attach material 292.

Reference is made to Figs. 13 and 14D, the method continues with step S24, where the first chips 250A is attached on the lead frame 270. In the present embodiments, the connection structures 280 and the first chips 250A are attached on the lead frame 270 simultaneously. Other structural details between the first chips 250A, 250B, and the lead frame 270 are similar to those described in step S13. Therefore, a description in this regard will not be repeated hereinafter for simplicity.

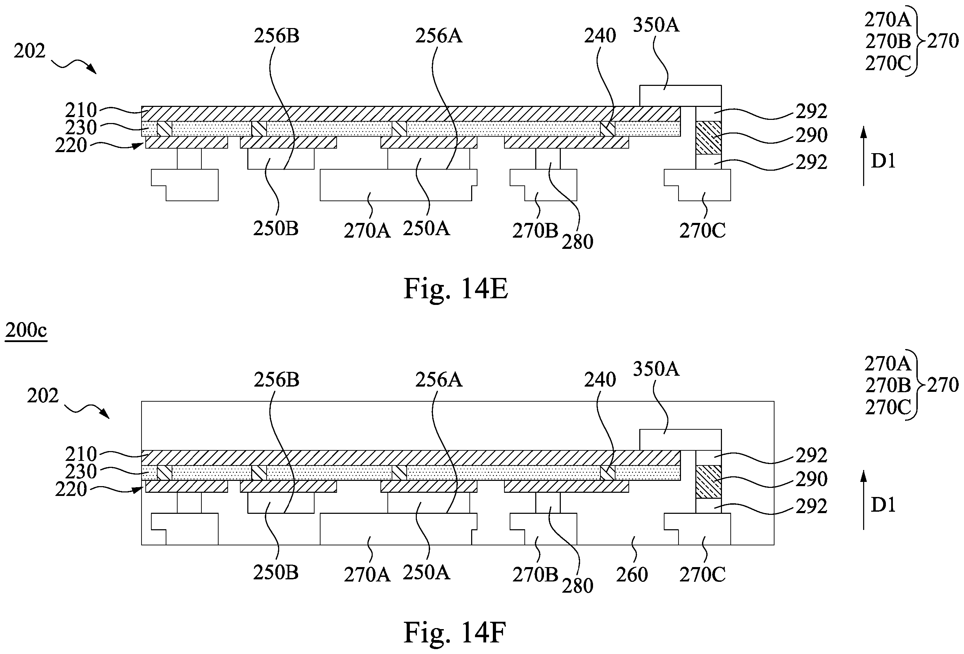

Reference is made to Figs. 13 and 14E, the method continues with step S25, where a second chip 350A is attached on the first conduction layer 210 and the pillar 290. The second chip 350A is attached on the pillar 290 by the attach material 292. Therefore, the second chip 350A is electrically connected with the first conductor layer 210 and the lead frame 270.

Reference is made to Figs. 13 and 14F, the method continues with step S26, where the encapsulation 260 is formed. The encapsulation 260 covers the substrate 202, the first chip 250A, the first chip 250B, the second chip 350A, the lead frame 270, and the pillar 290.

It is noted that the configuration of the package structure 200d in Fig. 10 can be formed by modifying the steps S21 and S22. For example, the step S21 can be modified to further include forming a plurality of portions 212 of the first conduction layer 210 and forming conductive vias 240 in the isolation layer 230. The step S22 can be modified to further include attaching a second chip 350B on the portions 212 of the first conduction layer 210.

As discussed above, with such configuration, the chips can be attached on both first conduction layer 210 and the second conduction layer 220, and the chips can be electrically connected to lead frame through connection structures 280 or pillar 290. Therefore, the number of chips that can be encapsulated in the package structure 200d can be further increased.

## Claims

1. A package structure (100), **characterized by** comprising:
a first conduction layer (110) comprising a plurality of first portions (112A);
a second conduction layer (120) comprising a plurality of portions (122), and
an isolation layer (130) disposed between the first conduction layer (110) and the second conduction layer (120), wherein the isolation layer (130) is composed of one of nitride and oxide mixed with at least one of epoxy and polymer.

2. The package structure (100) of claim 1, further comprising:
a conductive via (140) disposed between and in contact with the first conduction layer (110) and the second conduction layer (120).

3. The package structure (100) of one of the claims 1 to 2, wherein the first conduction layer (110) further comprises:
a second portion (112B) connecting with adjacent two of the first portions (112A) of the first conduction layer (110), wherein the second portion (112B) of the first conduction layer (110) has a top surface, and a portion of a top surface (1122B) of the second portion (112B) is free from coverage of the two first portions (112A).

4. The package structure (100) of one of the claims 1 to 3, further comprising:
a chip (150) electrically connected to the first conduction layer (110), wherein the chip (150) comprises a first side (154) and a second side (156) opposite to the first side (154), and the first side (154) faces the first conduction layer (110); and
an encapsulation(160) covering the chip (150) and the first conduction layer (110).

5. The package structure (100) of claim 4, wherein a portion of the second side (156) of the chip (150) is free from coverage of the encapsulation (160).

6. The package structure (100) of one of the claims 4 to 5, further comprising:
a connection structure (180) having a first side (184) electrically connected to the second side (156) of the chip (150) and the first conduction layer (110).

7. The package structure (100) of claim 6, wherein the connection structure (180) further comprises a second side (186) opposite to the first side (184) thereof, and a portion of the second side (186) of the connection structure (180) is free from coverage of the encapsulation (160).

8. The package structure (100) of one of the claims 4 to 7, further comprising:
an attach material (170) disposed between the first side (154) of the chip (150) and the first portions (112A) of the first conduction layer (110).

9. The package structure (100) of claim 8, further comprising:
an isolation material (190) isolating the attach material (170) from the encapsulation (160).

10. A method of forming a package structure (200), **characterized by** comprising:
forming a substrate (202) comprising a first conduction layer (210), a second conduction layer (220), and an isolation layer (230) disposed between the first conduction layer (210) and the second conduction layer (220);
attaching a first side (254A) of a first chip (250A) with the second conduction layer (220) of the substrate (202);
attaching a second side (256A) of the first chip (250A) opposite to the first side (254A) with a lead frame (270); and
encapsulating the substrate (202), the first chip (250A), and the lead frame (270).

11. The method of claim 10, wherein forming the substrate (202) comprises:
forming a conductive via (240) between the first conduction layer (210) and the second conduction layer (220).

12. The method of one of the claims 10 to 11, wherein forming the substrate (202) comprises:
forming the first conduction layer (110) comprising a plurality of first portions (112A) and a second portion (112B) connecting with adjacent two of the first portions (112A).

13. The method of one of the claims 10 to 12, further comprising:
attaching a connection structure (280) with the second conduction layer (220) of the substrate (202) before attaching the second side (256A) of the first chip (250A) with the lead frame (270); and
attaching the connection structure (280) with the lead frame (270).

14. The method of one of the claims 10 to 13, further comprising:
attaching a pillar (290) with the lead frame (270) before attaching the second side (256A) of the chip (250A) with the lead frame (270).

15. The method of claim 14, further comprising:
attaching a second chip (250B) with the first conduction layer (210) and the pillar (290) before encapsulating the substrate (202), the chip (250A), and the lead frame (270).
